# EUROPÄISCHE PATENTSCHRIFT

(11) **EP 2 999 807 B1**
(45) Veröffentlichungstag und Bekanntmachung des Hinweises auf die Patenterteilung: **06.03.2019**
(21) Anmeldenummer: 14728827.8
(22) Anmeldetag: 22.05.2014
(51) Int. Cl.: C23C 14/08, C23C 14/32, F02B 37/00

(54) **BARRIERESCHICHT FÜR TURBOLADER**
BARRIER COATING FOR TURBOCHARGERS
COUCHE BARRIÈRE POUR TURBOCOMPRESSEUR

(30) Priorität: 23.05.2013 US 201361826586 P
(43) Veröffentlichungstag der Anmeldung: 30.03.2016
(73) Patentinhaber: Oerlikon Surface Solutions AG, Pfäffikon, 8808 Pfäffikon SZ (CH)
(72) Erfinder: RAMM, Juergen, CH-7304 Maienfeld (CH)
(74) Vertreter: Misselhorn, Hein-Martin
(86) Internationale Anmeldenummer: PCT/EP2014/001390
(87) Internationale Veröffentlichungsnummer: WO 2014/187570

(56) Entgegenhaltungen:
- US-A1- 2005 006 006
- US-A1- 2008 193 782
- H. NAJAFI ET AL: "Formation of cubic structured (Al1-xCrx)2+[delta]O3 and its dynamic transition to corundum phase during cathodic arc evaporation", SURFACE AND COATINGS TECHNOLOGY, Bd. 214, 1. Januar 2013 (2013-01-01), Seiten 46-52, XP055134940, ISSN: 0257-8972, DOI: 10.1016/j.surfcoat.2012.10.062

## Beschreibung

Die vorliegende Erfindung betrifft ein System, insbesondere einen Turbolader mit einer Barriereschicht zum Schutz gegen Hochtemperaturkorrosion von Teilen und/oder Komponenten des Systems bzw. des Turboladers, welche hohen Temperaturen ausgesetzt werden.

### Stand der Technik

EP2112252 offenbart die Verwendung einer Barriereschicht aus Titandioxid oder eine Mischung aus Titandioxid mit mindestens einem anderen Keramikmaterial als Wärmedämmschicht zur Verringerung der Abgabe von Wärme von Teilen, wie beispielsweise von Turboladern. Diese Barriereschicht wird vorzugsweise mittels thermischen Spritzens aufgetragen.

US 2005/0006006 A1 offenbart einen Turbolader-Düsenring, der unter anderem mit einer auf Titan beruhenden PVD Oxidschicht beschichtet sein kann.

Deshalb sind manche Teile eines Turboladers gemäss dem Stand der Technik unvermeidbar hohen Temperaturen ausgesetzt. Solche Teile werden deswegen in der Regel aus sehr temperaturstabilen Materialien hergestellt, wie zum Beispiel Ni- und/oder Ti-Legierungen, welche sehr teuer und schwer herstellbar sind.

Bekannt sind auch Beschichtungen von Teilen von Turboladern für andere Zwecke. Beispielweise offenbaren EP2406476 und EP2041400 katalytische Beschichtungen, die auf Oberflächen von Turboladerteilen abgeschieden werden können. Gemäss EP2041400 kann eine solche katalytische Beschichtung als Mittel zur Verringerung von Schmutzablagerungen auf einem strömungsführenden Teil eines Verdichters eines Turboladers verwendet werden.

### Aufgabe der Erfindung

Der vorliegenden Erfindung liegt die Aufgabe zugrunde, eine Lösung anzubieten, um die Lebensdauer von Turboladerteilen, welche hohen Temperaturen ausgesetzt werden, zu erhöhen.

### Beschreibung der Erfindung

Diese Aufgabe wird erfindungsgemäss durch die in den Patentansprüchen angegebenen PVD-beschichteten Substrate gelöst.

Mit dem Begriff "hohe Temperaturen" sind im Rahmen der vorliegenden Erfindung Temperaturen über 400 °C gemeint, insbesondere über 500 °C.

Barriereschichten gemäss der vorliegenden Erfindung haben sich als eine hervorragende Barriere gegen Oxidation und chemische Angriffe erwiesen, insbesondere für Bauteile in Turboladern, welche Temperaturen bis 600° C und sogar bis 800 °C und mehr ausgesetzt werden.

Die Schicht wird erfindungsgemäss mittels eines PVD-Verfahrens, bevorzugt mittels reaktiven Funkenverdampfens ohne Dropletfilter abgeschieden.

Vorzugsweise umfasst die Schicht eine Interfaceschicht aus CrN und eine Funktionsschicht aus Al-Cr-O.

Weitere Einzelheiten der Erfindung werden anhand von Ausführungsbeispielen beschrieben:
Zur Herstellung der Schichten gemäss zwei Ausführungsbeispielen 1 und 2 wurden folgende Prozessparameter verwendet (siehe Tabellen 1 und 2):

**Tabelle 1: Prozessparameter bei der Abscheidung des Interfaces**

| Beispiel | Targets | Funkenstrom x Target | Substrattemperatur | Vorbehandlung (Ätzprozess) | Interface (Abscheidungsprozess) |
|---|---|---|---|---|---|
| 1 | 2xCr | Cr: 140 A | 450°C | Cr-Metal Ion Etch (18 min) | CrN (bel 3 Pa N2 für 13 min) |
| 2 | 2xCr | Cr: 140 A | 450°C | Cr-Metal Ion Etch (18 min) | CrN (bei 3 Pa N2 für 7 min) |

**Tabelle 2: Prozessparameter bei der Abscheidung der Funktionsschicht**

| Beispiel | Targets | Funkenstrom x Target | Substrattemperatur | Gasfluss | Funktionsschicht |
|---|---|---|---|---|---|
| 1 | 2xAlCr | AlCr: 200 A | 450°C | 400 sccm 02 | Al-Cr-O (für 60 min |
| 2 | 2xAlCr | AlCr: 200 A | 450°C | 400 sccm O2 | Al-Cr-O (für 30 min) |

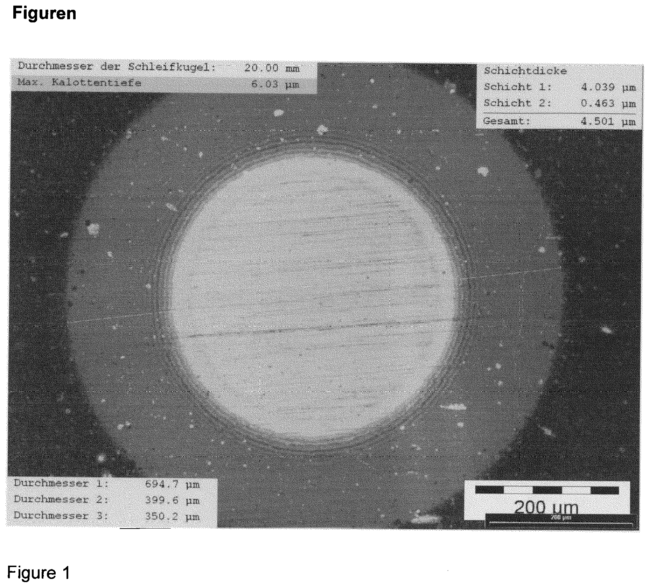

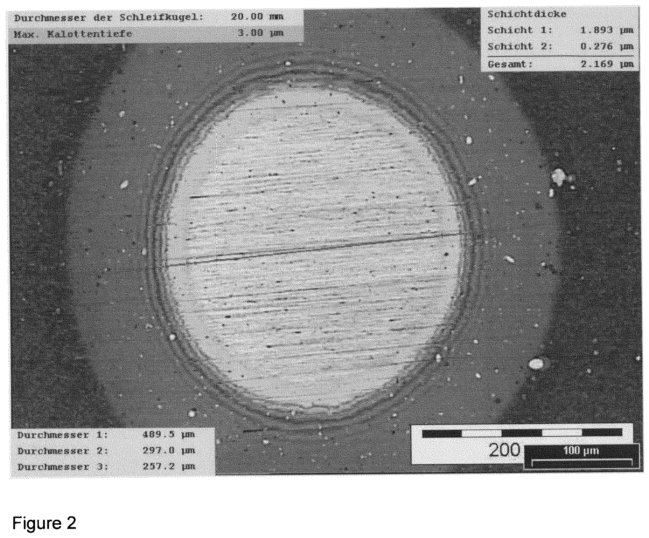

Die Schichtdicken der erfindungsgemäss hergestellten Schichten nach den Ausführungsbeispielen 1 und 2 wurden mit Hilfe eines Schichtdickenprüfgeräts nach dem Kalottenschleifverfahren gemessen (siehe Tabelle 3 und Figuren 1 und 2):

**Tabelle 3: Schichtdicke der der aus den Ausführurgsbeispielen 1 und 2 resultierenden Schichten 1 und 2**

| Beispiel | Dicke Interface | Dicke Funktionsschicht |
|---|---|---|
| 1 | 0.5 µm | 4.0 µm |
| 2 | 0.3 µm | 1.9 µm |

Zur Herstellung der Al-Cr-O Schichten gemäss der vorliegenden Erfindung werden vorzugsweise Targets mit einer Al₁₋ₓCrₓ Zusammensetzung mit 0.2≤, x≤0.9 in atomarer Konzentration benutzt. Im Allgemeinen werden diese Targets pulvermetallurgisch gefertigt, sodass beliebige chemische Zusammensetzungen im angegebenen Bereich hergestellt werden können.

Vorzugsweise werden die Targets in einer Sauerstoffatmosphäre verdampft, wie es bereits bei den oben beschriebenen Ausführungsbeispielen 1 und 2 angegeben wurde. Die Targets können erfindungsgemäss mit unterschiedlichen Funkenströmen betrieben werden, um die Verdampfungsrate zu steuern.

Erfindungsgemäss wird die chemische Zusammensetzung der Schichten so gesteuert, dass die Analyse einer auf diese Weise hergestellten Schicht eine Komposition von (Al,Cr)₂O_{3-y} ergibt, wobei y≤ 0.3 ist.

Je nach Fall kann die Beschichtungstemperatur dem zu beschichtenden Substratmaterial und der späteren Anwendung angepasst werden. Typischerweise liegen die Beschichtungstemperaturen zwischen 100°C und 600°C.

Da die zu beschichtenden Substrate unterschiedliche Formen und Grössen besitzen können, wird die Substrathalterung, mit der sie während der Beschichtung in der Anlage gehaltert werden, in ihrer Ausführungsform der Substratform angepasst.

All das führt dazu, dass zwar in allen Fällen die oben beschriebene chemische Zusammensetzung eingehalten wird, dass sich aber durchaus andere Phasenzusammensetzungen der Oxidschicht für die unterschiedlichen Prozessparameter ergeben.

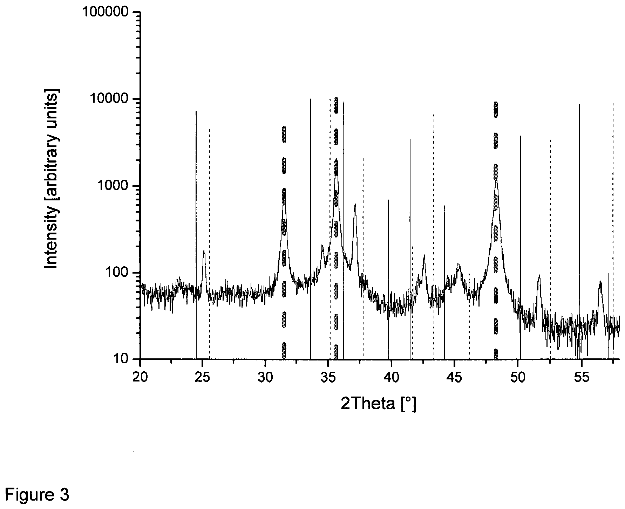

Die Phasen der Schicht werden üblicherweise mit der Methode der Röntgenbeugung (XRD) gemessen. Deshalb kann das gemessene XRD Spektrum in einigen Fällen deutlich die Reflexe für eine (Al,Cr)₂O₃-Schicht in Korundstruktur zeigen, wie es beispielsweise in der Figur 3 dargestellt ist. In diesem Fall zeigt die Figur 3 das Röntgenbeugungsdiagramm einer (Al,Cr)₂O₃-Schicht, welche von einem Al_{0.7}Cr_{0.3} - Target hergestellt wurde.

In der Abbildung sind die XRD Reflexe der Positionen des Wolframkarbidsubstrates (dicke gestrichelte Linie) und die Positionen für die Beugungsreflexe von Cr₂O₃ in Eskolaite-Struktur (durchgezogene Linie) und Al₂O₃ in Korundstruktur (gestrichelte Linie) eingezeichnet. Zwischen diesen beiden Linien findet sich jeweils der gemessene Beugungsreflex für den synthetisierten (Al,Cr)₂O₃-Mischkristall in Korundstruktur, wie es nach dem Vegards-Gesetz zu erwarten ist.

Falls man aber die Prozessbedingungen wie oben beschrieben ändert, kann es dazu kommen, dass die Kristal litgrösse des Oxides so klein wird, dass die Kristallite mit XRD nicht mehr detektiert werden können, oder es kann auch sein, dass durch die Änderung der Prozessbedingungen die Struktur des resultierenden Oxids sogar amorph wird.

In solchen Fällen kann man das Oxid im Röntgenspektrum nicht mehr detektieren, aber in fast allen Fällen kann man dann materialverwandte Verbindungen, vor allem intermetallische Phasen und metallische Mischkristalle der Al-Cr-O-Schicht finden. Eine solche materialverwandte Verbindung ist beispielsweise die intermetallische Phase Al₈Cr₅.

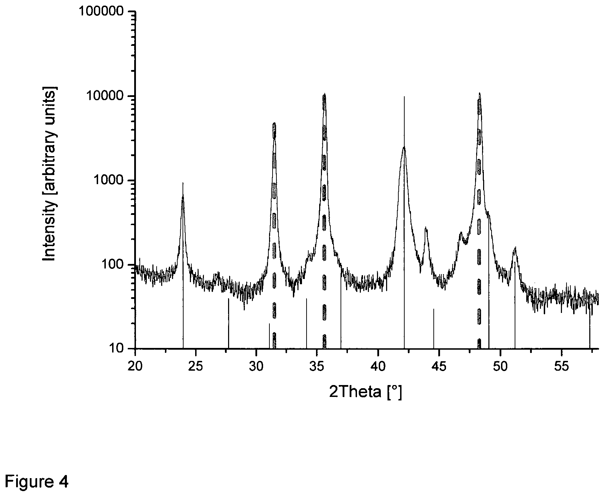

Ein entsprechendes Röntgenbeugungsdiagramm ist in der Figur 4 dargestellt, bei der ein an einer Schicht gemessenes Röntgenspektrum gezeigt wird, in dem man, obwohl man keine Oxidphase detektieren kann, die materialverwandte intermetallische Phase Al₈Cr₅ deutlich sieht. In diesem Röntgenbeugungsdiagramm sind wieder die Beugungsreflexe für das Wolframkarbidsubstrat (dicke gestrichelte Linie) verdeutlicht und zusätzlich sind die Beugungsreflexe für die Al₈Cr₅ Kristallstruktur (durchgezogene Linie) eingezeichnet, die deutlich das Vorhandensein dieser intermetallischen Verbindung in der Oxidschicht belegen.

Ganz analog kann es unter bestimmten Prozessbedingungen dazu kommen, dass man mittels XRD in der Oxidschicht, deren chemische Zusammensetzung oben beschrieben wurde, beispielsweise auch Al₄Cr₁ oder Al₉Cr₄ oder weitere Al-Cr intermetallisch Verbindungen oder Mischkristalle detektiert, einzeln oder zusammen.

### Bildunterschriften

Figur 1 : Kalottenschliffmessung zur Auswertung der Schichtdicke der aus dem Ausführungsbeispiel 1 resultierenden Schicht 1.
Figur 2: Kalottenschliffmessung zur Auswertung der Schichtdicke der aus dem Ausführungsbeispiel 1 resultierenden Schicht 2.
Figur 3: Röntgenbeugungsdiagramm einer (Al,Cr)₂O₃-Schicht, welche von einem Al_{0.7}Cr_{0.3} -Target hergestellt wurde und deutlich die Reflexe für eine (Al,Cr)₂O₃-Schicht in Korundstruktur zeigt.
Figur 4: Röntgenbeugungsdiagramm einer (Al,Cr)₂O₃-Schich,t welche von einem Al_{0.7}Cr_{0.3} -Target hergestellt wurde und deutlich die Reflexe der Kristallstruktur der intermetallischen Phase Al₈Cr₅ zeigt.

## Patentansprüche

1. PVD-beschichtetes Substrat mit einer Oxidations- und chemischen Barriereschicht, wobei das Substrat ein Teil oder ein Bauteil eines Systems ist, welches beim Betrieb des Systems hohen Temperaturen ausgesetzt wird, **dadurch gekennzeichnet, dass**
- das System ein Turbolader ist,
- das Substrat ein Teil oder Bauteil des Turboladers ist, welches hohen Temperaturen über 400° C ausgesetzt wird,
- die Barriereschicht mindestens eine Al-Cr-O Schicht umfasst, welche eine Komposition von (Al,Cr)₂O₃-y mit y≤0.3 aufweist, und wobei das Röntgenbeugungsdiagramm die Reflexe einer Kristallstruktur einer AlCrintermetallischen Phase zeigt.

2. PVD-beschichtetes Substrat nach Anspruch 1, wobei die Barriereschicht eine Chromnitridschicht, umfasst welche sich zwischen dem Substrat und der Al-Cr-O Schicht befindet.

3. PVD-beschichtetes Substrat nach einem der vorhergehenden Ansprüche 1 bis 2, wobei das Röntgenbeugungsdiagramm der Al-Cr-O Schicht die Reflexe einer (Al,Cr)₂O₃-Schicht in Korundstruktur zeigt.

4. PVD-beschichtetes Substrat nach Anspruch 1 bis 2, wobei die Kristallgrösse des Oxides so klein ist, dass die Kristallite mit XRD nicht detektiert werden können.

## Claims

1. A PVD-coated substrate with an oxidation and a chemical barrier layer, wherein the substrate is a part or component of a system exposed to high temperatures during the operation of the system, **characterized in that**
- the system is a turbocharger,
- the substrate is a part or component of a turbocharger exposed to high temperatures above 400°C,
- the barrier layer comprises at least one Al-Cr-O layer having a composition of (Al,Cr)₂O₃-y, where y ≤ 0.3, and wherein the X-ray diffraction diagram shows the reflections of a crystal structure of an AlCr-intermetallic phase.

2. The PVD-coated substrate according to claim 1, wherein the barrier layer comprises a chromium nitride layer, which is located between the substrate and the Al-Cr-O layer.

3. The PVD-coated substrate according to any one of the preceding claims 1 to 2, wherein the X-ray diffraction diagram of the Al-Cr-O layer shows the reflections of an (Al,Cr)₂O₃ layer in a corundum structure.

4. The PVD-coated substrate according to claim 1 to 2, wherein the crystal size of the oxide is so small that the crystallites cannot be detected by means of XRD.

## Revendications

1. Substrat revêtu par PVD comportant une couche de barrière d'oxydation et chimique, le substrat étant un élément ou un composant d'un système soumis à des températures élevées pendant le fonctionnement du système, **caractérisé en ce que**
- le système est un turbocompresseur,
- le substrat est un élément ou un composant du turbocompresseur, qui est soumis à des températures élevées supérieures à 400 °C,
- la couche de barrière comprend au moins une couche en Al-Cr-O qui présente une composition de (Al, Cr)₂O₃-y avec y ≤ 0,3, et le diagramme de diffraction des rayons X présentant les réflexes d'une structure cristalline d'une phase intermétallique en AlCr.

2. Substrat revêtu par PVD selon la revendication 1, dans lequel la couche de barrière comprend une couche de nitrure de chrome qui se situe entre le substrat et la couche en Al-Cr-O.

3. Substrat revêtu par PVD selon l'une des revendications précédentes 1 à 2, dans lequel le diagramme de diffraction des rayons X de la couche en Al-Cr-O présente les réflexes d'une couche (Al, Cr)₂O₃ en structure de type corindon.

4. Substrat revêtu par PVD selon la revendication 1 à 2, dans lequel la taille cristalline de l'oxyde est si petite que les cristallites ne peuvent pas être détectées par XRD.
